# EUROPEAN PATENT APPLICATION

(11) **EP 3 042 980 A1**
(43) Date of publication of application: **13.07.2016**
(21) Application number: 14842890.7
(22) Date of filing: 03.09.2014
(51) Int. Cl.: C23C 18/20, C08L 101/12, C08L 77/00, C08K 3/22, H05K 3/18

(54) **THERMOPLASTIC RESIN COMPOSITION, RESIN MOLDED ARTICLE, AND METHOD FOR PRODUCING PLATING-LAYER-EQUIPPED RESIN MOLDED ARTICLE**

(30) Priority: 05.09.2013 JP 2013184023
(71) Applicant: Mitsubishi Engineering-Plastics Corporation, Tokyo 105-0021 (JP)
(72) Inventor: TAKANO Takahiro, Hiratsuka-shi Kanagawa 254-0016 (JP); YAMADA Ryusuke, Hiratsuka-shi Kanagawa 254-0016 (JP); AYUBA Shinichi, Hiratsuka-shi Kanagawa 254-0016 (JP)
(74) Representative: Ishiguro, Masaoki
(86) International application number: PCT/JP2014/073182
(87) International publication number: WO 2015/033955

(57) **Abstract**

Provided is a thermoplastic resin composition capable of producing a resin molded article having high resistance to soldering heat, good platability (appearance of plating layer), high thermal conductivity and high volume resistivity. The thermoplastic resin composition includes, per (A) 100 parts by weight of crystallizable thermoplastic resin showing a melting point of 250°C or higher when measured by differential scanning colorimetry (DSC) at a temperature elevation rate of 10°C/min; (B) 40 to 150 parts by weight of insulating thermal conductive filler showing a thermal conductivity of 10 w/m·K or larger; (C) 3 to 20 parts by weight of laser direct structuring additive; and (D) 10 to 130 parts by weight of titanium oxide; wherein a total content of the (B) insulating thermal conductive filler, the (C) laser direct structuring additive and the (D) titanium oxide is 40 to 65% by weight of the resin composition.

## Description

### TECHNICAL FIELD

This invention relates to a thermoplastic resin composition, and in particular to a thermoplastic resin composition for use in laser direct structuring. This invention further relates to a resin molded article obtained by molding the thermoplastic resin composition, and, a method for manufacturing a resin molded article having a plating layer formed on the surface of the resin molded article.

### BACKGROUND ART

In recent years, a new series of light sources, such as light emitting diode (LED), organic EL and so forth, have expanded their demand for lighting and display elements, making good use of their low power consumption and long service life. In particular, LED has been used for various applications including mobile communication devices such as cellular phone, display, automobile console panel, traffic signal, and other home appliances. These electric and electronic equipment have been unceasingly reduced in size and weight, to satisfy requirements for design and portability.

As a key technology for embodying such reduction in size and weight, surface mounting technology (SMT) has been used widely, and applied to a wide range of electric and electronic equipment. With this technology, mounting density on electronic circuit board has been improved dramatically, leading to an unprecedented level of reduction in size and weight.

When SMT is applied, only materials resistant to soldering temperature (230 to 240°C) are usable, since whole bodies of components are subjected to soldering, in their mounted state on the electronic circuit board. Heat-resistant resin composition is one known material usable for such application (see Patent Literature 1, for example).

Now, laser direct structuring (occasionally referred to as "LDS", hereinafter) has attracted public attention, as a technique capable of forming a plating layer directly on resin molded article or the like, and is adoptable to three-dimensional design. LDS is typically a technique of irradiating, with laser, the surface of the resin molded article which contains an LDS additive to thereby selectively activate the irradiated portion, and then applying a metal to the activated portion to thereby form the plating layer. The advantage of this technique resides in that metal structures may be fabricated on the surface of resin base, without using adhesive. The LDS technique is disclosed, for example, in Patent Literatures 2 to 4.

### CITATION LIST

### PATENT LITERATURE

[Patent Literature 1] JP-A-2004-075994
[Patent Literature 2] JP-T-2000-503817
[Patent Literature 3] JP-T-2004-534408
[Patent Literature 4] International Patent WO2009/141800, Pamphlet

### SUMMARY OF THE INVENTION

### TECHNICAL PROBLEM

LED is typically composed of a light-emitting semiconductor component, lead wires, a reflector which also serves as a housing, and a clear encapsulant for encapsulating the semiconductor component. Among them, components for LED lighting circuit, such as those for the reflector part, are also required to be usable as a heatsink which is excellent in heat conduction performance and electric insulation performance. In other words, high thermal conductivity and high volume resistivity are required.

Meanwhile, the reflector part has been commercialized using ceramic material which is, however, poor in terms of productivity. While there has been an idea of commercializing the reflector part using heat-resistant resin composition, there is concern over degraded reflectivity of light due to discoloration which occurs in the process of injection molding, heat curing of encapsulant, or under the actual environment of use. It is therefore difficult to use the heat-resistant resin composition in applications where high reflectivity is required.

It is therefore an object of this invention to solve the above-described problems, and to provide a thermoplastic resin composition capable of producing a resin molded article having high resistance to soldering heat, good platability (appearance of plating layer), high thermal conductivity and high volume resistivity. It is another object of this invention to provide a thermoplastic resin composition usable for applications where high reflectivity is required.

### SOLUTION TO PROBLEM

After intensive studies considering the problems, the present inventors found that the problems described above may be solved by mixing a crystallizable thermoplastic resin, which shows the melting point at 250°C or higher when measured by differential scanning colorimetry (DSC) at a temperature elevation rate of 10°C/min, with a specific insulating thermal conductive filler, a laser direct structuring additive, and titanium oxide, while controlling their contents to predetermined values. The finding led us to work out this invention.

More specifically, the problems described above were solved by means <1> below, and preferably by means <2> to <14>.
<1> A thermoplastic resin composition comprising: per (A) 100 parts by weight of crystallizable thermoplastic resin showing a melting point of 250°C or higher when measured by differential scanning colorimetry (DSC) at a temperature elevation rate of 10°C/min; (B) 40 to 150 parts by weight of insulating thermal conductive filler showing a thermal conductivity of 10 w/m·K or larger; (C) 3 to 20 parts by weight of laser direct structuring additive; and (D) 10 to 130 parts by weight of titanium oxide; wherein a total content of the (B) insulating thermal conductive filler, the (C) laser direct structuring additive and the (D) titanium oxide is 40 to 65% by weight of the resin composition.
<2> The thermoplastic resin composition of <1>, further comprising (E) 10 to 200 parts by weight of glass fiber, per (A) 100 parts by weight of the crystallizable thermoplastic resin.
<3> The thermoplastic resin composition of <1> or <2>, wherein the (A) crystallizable thermoplastic resin is a polyamide resin.
<4> The thermoplastic resin composition of any one of <1> to <3>, wherein the (B) insulating thermal conductive filler is at least one species selected from boron nitride, aluminum nitride and aluminum oxide.
<5> The thermoplastic resin composition of any one of <1> to <4>, wherein the (C) laser direct structuring additive is one or more species selected from the group consisting of:
   (1) additive containing antimony and tin;
   (2) additive containing copper-containing oxide;
   (3) additive comprising a core which is composed of a composition having a reflectivity of 50% or larger at 450 nm wavelength, the surface of which being partially or entirely coated with a composition containing at least one of copper-containing oxide, and, tin and antimony-containing oxide; and
   (4) additive containing at least two species of metals, and an electro-conductive oxide having a resistivity 5×10³ Ω·cm or smaller.
<6> A thermoplastic resin composition comprising:
   per 100 parts by weight of xylylenediamine-based polyamide resin, in which 70 mol% or more of its diamine-derived constitutive unit being derived from metaxylylenediamine and/or paraxylylenediamine, and 70 mol% or more of its dicarboxylic acid-derived constitutive unit being derived from an α,ω-straight chain aliphatic dicarboxylic acid having 4 to 20 carbon atoms;
      (B) 40 to 150 parts by weight of insulating thermal conductive filler showing a thermal conductivity of 10 W/m·K or larger;
      (C) 3 to 20 parts by weight of laser direct structuring additive; and
      (D) 10 to 130 parts by weight of titanium oxide;
   wherein a total content of the (B) insulating thermal conductive filler, the (C) laser direct structuring additive and the (D) titanium oxide being 40 to 65% by weight relative to the resin composition.
<7> A resin molded article obtained by molding the thermoplastic resin composition described in any one of <1> to <6>.
<8> The resin molded article of <7>, wherein the volume resistivity is 1.0×10⁸ Ω·cm or larger.
<9> The resin molded article of <7> or <8>, wherein the reflectivity at 450 nm wavelength is 25% or larger.
<10> The resin molded article of any one of <7> to <9>, which has a thermal conductivity of larger than 1.0 W/m·K.
<11> The resin molded article of any one of <7> to <10>, further comprising a plating layer provided to a surface thereof.
<12> The resin molded article of any one of <7> to <11>, which is an LED lighting circuit component.
<13> A method for manufacturing a resin molded article with a plating layer, the method comprising:
   irradiating, with laser, the surface of a resin molded article obtained by molding the thermoplastic resin composition described in any one of <1> to <6>, and applying a metal to form the plating layer.
<14> The method for manufacturing a resin molded article with a plating layer of <13>,
   wherein the plating layer is a copper plating layer.

### ADVANTAGEOUS EFFECTS OF INVENTION

With this invention, it became possible to provide a resin molded article having high resistance to soldering heat, excellent platability (appearance of plating), and, showing high thermal conductivity and high volume resistivity. It also became possible to provide a thermoplastic resin composition usable for applications where high reflectivity is required.

### BRIEF DESCRIPTION OF DRAWINGS

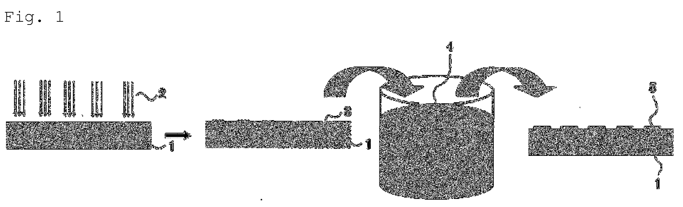

[FIG. 1] A schematic drawing illustrating steps of providing a plating layer on the surface of a resin molded article.

### DESCRIPTION OF EMBODIMENTS

This invention will be detailed below. Note that, in this specification, all numerical ranges given in the form of "to" preceded and succeeded by numerals shall be defined to contain these numerals as the lower and upper limit values. L values in this specification shall be defined by values measured in compliance with JIS K7105.

The thermoplastic resin composition of this invention contains per (A) 100 parts by weight of crystallizable thermoplastic resin showing a melting point of 250°C or higher when measured by differential scanning colorimetry (DSC) at a temperature elevation rate of 10°C/min; (B) 40 to 150 parts by weight of insulating thermal conductive filler showing a thermal conductivity of 10 W/m·K or larger; (C) 3 to 20 parts by weight of laser direct structuring additive; and (D) 10 to 130 parts by weight of titanium oxide, wherein the total content of the (B) insulating thermal conductive filler, the (C) laser direct structuring additive and the (D) titanium oxide accounts for 40 to 65% by weight of the resin composition. By using a specific insulating thermal conductive filler in combination with titanium oxide, and, by mixing the insulating thermal conductive filler, the LDS additive and titanium oxide into the composition according to a predetermined ratio, it becomes possible to provide a thermoplastic resin composition having high heat conduction performance, high volume resistivity and high resistance to soldering heat, and, showing excellent platability. The thermoplastic resin composition of this invention will be detailed below.

### < (A) Crystallizable Thermoplastic Resin Showing Melting Point of 250°C or Higher when Measured by Differential Scanning Colorimetry (DSC) at Temperature Elevation Rate of 10°C/min>

The crystallizable thermoplastic resin (A) used in this invention is characterized in that it shows a melting point of 250°C or higher, when measured by differential scanning colorimetry (DSC) at a temperature elevation rate of 10°C/min. The melting point is preferably 255°C or higher. The upper limit is typically, but not specifically limited to, 350°C or below. By employing this sort of resin, the product dimension during reflow soldering will be stabilized more effectively.

The crystallizable thermoplastic resin means a thermoplastic resin having a crystalline structure or a crystallizable molecular structure, showing non-vitreous characteristics, showing measurable heat of fusion, and showing a clear melting point. The melting point and heat of fusion may be measured using a differential scanning colorimetric apparatus, such as DSC-II from PerkinElmer Inc. More specifically, the crystallizable thermoplastic resin is defined if it shows a heat of fusion of 1 cal/g or more when measured using this apparatus. The melting point may be measured using the differential scanning colorimetric apparatus, by heating a sample up to a temperature not lower than the predicted melting point of the sample, at a heating rate of 10°C/min, then cooling the sample down to 20°C at a cooling rate of 10°C/min, allowing the sample to stand for approximately one minute, and again heating the sample at a heating rate of 10°C/min. Unless otherwise specifically noted, the crystallizable thermoplastic resin in the context of this specification hereinafter means "crystallizable thermoplastic resin showing a melting point of 250°C or higher when measured by differential scanning colorimetry (DSC)".

The crystallizable thermoplastic resin used in this invention is specifically exemplified by polyolefin resin, polyester resin, polyacetal resin, polyphenylene sulfide resin, polyamide resin, and liquid crystal polymer, wherein polyamide resin is preferred. The crystallizable thermoplastic resin may be a single substance or may be mixture of two or more species of resins.

As for the polyester resin, the description in paragraphs [0013] to [0016] of JP-A-2010-174223 may be referred to.

As for polyacetal resin, the descriptions in paragraph [0011] of JP-A-2003-003041, and in paragraphs [0018] to [0020] of JP-A-2003-220667 may be referred to.

As for the polyamide resin, the description in paragraphs [0011] to [0013] of JP-A-2011-132550 may be referred to.

In this invention, a particularly preferable polyamide resin contains aromatic rings in the molecule thereof, with the ratio of carbon atoms composing the aromatic rings, relative to the polyamide resin molecule, being 30 mol% or larger.

A more preferable polyamide resin is a xylylenediamine-based polyamide resin in which 50 mol% or more of the diamine constitutive unit (diamine-derived constitutive unit) is derived from xylylenediamine, and is polycondensed with dicarboxylic acid.

A particularly preferable xylylenediamine-based polyamide resin is such that 70 mol% or more, and more preferably 80 mol% or more, of the diamine constitutive unit is derived from metaxylylenediamine and/or paraxylylenediamine, and that 50 mol% or more, more preferably 70 mol% or more, and particularly 80 mol% or more of the dicarboxylic acid constitutive unit (dicarboxylic acid-derived constitutive unit) is derived from α,ω-straight chain aliphatic dicarboxylic acid having 4 to 20 carbon atoms. Examples of the α, ω-straight chain aliphatic dibasic acid having 4 to 20 carbon atoms, which are suitably used, include adipic acid, sebacic acid, suberic acid, dodecanedioic acid, and eicosadienoic acid, wherein adipic acid and/or sebacic acid are most preferable.

By employing such polyamide resin, it becomes possible to easily obtain the resin showing a melting point of 250°C or higher when measured by DSC.

The crystallizable thermoplastic resin used in this invention preferably has a glass transition point of 40 to 180°C, more preferably 60 to 130°C.

The crystallizable thermoplastic resin used in this invention preferably has a number-average molecular weight of 5000 to 45000, more preferably 10000 to 25000.

In the thermoplastic resin composition of this invention, the content of the crystallizable thermoplastic resin is preferably 10 to 80% by weight, and more preferably 30 to 70% by weight. In the resin component contained in the thermoplastic resin composition of this invention, the ratio of polyamide resin is preferably 90% by weight or more.

### <(B) Insulating Thermal conductive Filler Showing Thermal Conductivity of 10 W/m·K or Larger>

The thermoplastic resin composition of this invention contains, besides titanium oxide, (B) insulating thermal conductive filler showing a thermal conductivity of 10 W/m·K or larger (also referred to as "thermal conductive filler", hereinafter). With the thermal conductive filler contained therein, the thermoplastic resin composition of this invention will be improved in the heat radiation performance.

The thermal conductivity of the thermal conductive filler is 10 W/m·K or larger, preferably 15 W/m·K or larger, and more preferably 60 W/m·K or larger. The upper limit is typically, but not specifically limited to, 300 W/m·K or below, and preferably 200 W/m·K or below.

While the thermal conductive filler in the thermoplastic resin composition of this invention is not specifically limited so long as it is a filler showing a thermal conductivity of 10 W/m·K or larger, it is preferably at least one of boron nitride, aluminum nitride and aluminum oxide, and is more preferably boron nitride since there will be a relatively low risk of metal wear of an extruder when compounded into the thermoplastic resin. Alternatively, among the thermal conductive fillers described in paragraph [0029] of JP-A-2013-53188, and the thermal conductive fillers described in paragraph [0026] of JP-5109186-B2, also those showing a thermal conductivity of 10 W/m·K or larger are suitably used.

The thermal conductive filler in the thermoplastic resin composition of this invention may have a variety of geometries including grain, plate, scale, powder and so forth, without special limitation.

Boron nitride preferably has a scaly or flaky form. When made into a flaky form, the filler will more easily align in the molded article in the in-plane direction, to thereby enhance the heat conduction performance. Average size of the scaly boron nitride is preferably 1 to 200 µm in view of effectively making up a heat conduction path by filler orientation, more preferably 5 to 100 µm, and even more preferably 5 to 30 µm. Crystal system of boron nitride is exemplified by, but not limited to, hexagonal system and cubic system. In particular, boron nitride having hexagonal crystal structure is preferable owing to its high heat conduction performance.

Aluminum nitride preferably has a grain form. The average size is preferably 0.5 to 200 µm, more preferably 1 to 100 µm, even more preferably 1 to 30 µm, and yet more preferably 1 to 20 µm. Crystal system of aluminum nitride is exemplified by, but not limited to, hexagonal system and cubic system.

Aluminum oxide preferably has a grain form. Average size of aluminum oxide is preferably 0.1 to 200 µm, more preferably 0.5 to 100 µm, even more preferably 1 to 30 µm, and particularly 2 to 10 µm. Crystal system of aluminum oxide is exemplified by, but not limited to, trigonal system and cubic system.

These thermal conductive fillers may be used after subjected to surface treatment aimed at enhancing affinity to the polyamide resin. Surface treatment agent suitable for this purpose is selectable, without special limitation, from known agents, wherein silane coupling agent and titanium coupling agent may be used. For details of these agents, the description in paragraphs [0028] to [0039] of JP-5109186-B1 may be referred to, the content of which is incorporated into this specification. The amount of use of these agents preferably falls in the range from 0.1 to 3.0% by weight, relative to the thermal conductive filler.

Even after the surface treatment, the thermal conductive filler shows an electric insulation performance. Although the electric insulation performance is not specifically limited, it is preferably represented by a volume resistivity, measured in compliance with JIS K6911, of 1.0×10⁸ Ω·cm or larger, more preferably 1.0×10¹² Ω·cm or larger, and even more preferably 1.0×10¹⁴ Ω·cm or larger. The upper limit is typically 1.0×10¹⁶ Ω·cm or below, but not specifically limited thereto.

The content of the thermal conductive filler in the thermoplastic resin composition of this invention is 40 to 150 parts by weight, per 100 parts by weight of the crystallizable thermoplastic resin, preferably 50 to 130 parts by weight, and even more preferably 70 to 120 parts by weight. Only a single species of thermal conductive filler may be used, or two or more species may be used in combination. When two or more species are used, the total content preferably falls in the above-described ranges.

### <(C) Laser Direct Structuring Additive>

The thermoplastic resin composition of this invention contains an LDS additive.

The LDS additive in this invention is a compound capable of forming a plating layer, when 4 parts by weight of an additive which is supposed to be an LDS additive is added to 100 parts by weight of PAPXD10 or PAMP6 (synthesis of PAMP 6 will be described later in Example), the resin is irradiated with YAG laser of 1064 nm wavelength at an output of 10 W, a frequency of 80 kHz, and a speed of 3 m/s, and the work is put into M-Copper 85 electroless plating bath from MacDermid Inc. so as to apply a metal onto the laser-irradiated surface. If the resin added with the additive shows only a poor absorption of YAG laser and is not burnt on the surface uniformly, 10 to 40 parts by weight of titanium oxide may be added to assist the laser burning of the surface for evaluation.

The LDS additive used in this invention may be a synthetic one or may be a commercially available one. The commercially available one may be any of those marketed as the LDS additive, or may be those directed to other applications so long as they satisfy the requirements of the LDS additive in this invention. Although many of known LDS additives have been black, the LDS additive employed in this invention is not black, and is therefore able to color the resin molded article.

The content of the LDS additive in the thermoplastic resin composition of this invention is 3 to 20 parts by weight, per 100 parts by weight of the crystallizable thermoplastic resin, preferably 5 to 20 parts by weight, more preferably 10 to 20 parts by weight, and particularly 13 to 18 parts by weight. Only a single species of the LDS additive may be used, or two or more species may be used in combination. When two or more species are used, the total content preferably falls in the above-described ranges.

Preferred embodiments of the LDS additive used in this invention will be described below. By using such LDS additive of the embodiments, the effects of this invention will be more likely to be demonstrated. However, this invention is of course not limited to these embodiments.

The LDS additive of a first embodiment used in this invention preferably contains at least one of antimony and tin, more preferably contains antimony and tin, even more preferably antimony and tin with a larger content of tin over antimony, and particularly contains antimony and tin oxide with a larger content of tin over antimony. Also preferably exemplified is the case where antimony oxide and tin oxide are contained, with a larger content of tin over antimony. In this embodiment, tin preferably accounts for 80% by weight or more of the metal component. In this invention, it is particularly preferable to use the LDS additive having a reflectivity at 450 nm wavelength of 50% or larger, from a viewpoint of improving the reflectivity.

The LDS additive of a second embodiment used in this invention relates to a copper-containing LDS additive. The LDS additive used in the second embodiment is preferably a copper-containing oxide, and more preferably an oxide containing copper and chromium (copper-chromium oxide). Such LDS additive is exemplified by CuCr₂O₄ and Cu₃(PO₄)₂Cu(OH)₂, where CuCr₂O₄ is particularly preferable.

By using the copper-containing oxide as the LDS additive as described above, the effects of this invention will be more likely to be demonstrated. In the LDS additive used in the second embodiment, the copper content is preferably 20 to 95% by weight.

The LDS additive of a third embodiment of this invention preferably includes a core which is composed of a composition having a reflectivity of 50% or larger at 450 nm wavelength, the surface of which being partially or entirely coated with a composition containing at least one of copper, tin and antimony, and more preferably being coated with a composition containing at least one of copper-containing oxide, and, tin and antimony-containing oxide. Even more preferably, the LDS additive includes a core which is composed of a composition having a reflectivity of 50% or larger, wherein 60% or more of the surface area of the core being coated with a composition containing at least one of copper, tin and antimony. With such configuration, the composition containing at least one of copper, tin and antimony will more widely expose to the surface, so that even a composition containing small amount(s) of at least one of copper, tin and antimony can demonstrate the LDS effect. Moreover, by employing the composition having a reflectivity of 50% or larger as the composition for composing the core, the thermoplastic resin composition of this invention will successfully have high reflectivity.

The reflectivity of the composition composing the core is preferably 80% or larger.

The composition having a reflectivity of 50% or larger, for composing the core, preferably contains a metal oxide, and more preferably contains at least one of silicon dioxide, mica and titanium oxide. As an embodiment of this invention, exemplified is an embodiment in which 20% by weight or more of the composition, having a reflectivity of 50% or larger for composing the core, is the metal oxide (preferably, the composition is composed of substantially the metal oxide only).

The composition to be coated, containing at least one of copper, tin and antimony is preferably a composition containing antimony and tin, more preferably a composition containing antimony and tin, with a larger content of tin over antimony, and even more preferably a composition containing antimony and tin oxide, with a larger content of tin over antimony. Also preferably exemplified is a composition containing antimony oxide and tin oxide, with a larger content of tin over antimony.

When antimony and tin are contained, the ratio by weight is preferably "3.5:96.5" to "25:75", and more preferably "7.5:92.5" to "20:80".

When the LDS additive has the core composed of a composition having a reflectivity of 50% or larger, and the surface of which is partially or entirely coated with a composition containing at least one of copper, tin and antimony, ratio by weight of the composition composing the core and the composition composing the coating part is preferably (40 to 90) : (60 to 10), and more preferably (70 to 90) : (30 to 10).

As the LDS additive in this invention, suitably used is antimony-doped tin; antimony-doped tin oxide and antimony oxide-doped tin oxide; and a material having any of these substances coated on the surface of a core which is composed of a composition having a reflectivity of 50% or larger.

The LDS additive used in a fourth embodiment of this invention preferably contains at least two species of metals, and, an electro-conductive oxide having a resistivity of 5×10³ Ω·cm or smaller. The electro-conductive oxide preferably has a resistivity of 8×10² Ω·cm or smaller, more preferably 7×10² Ω·cm or smaller, and even more preferably 5×10² Ω·cm or smaller. The lower limit is typically, but not specifically limited to, 1×10¹ Ω·cm or above, and more preferably 1×10² Ω·cm or above.

The resistivity of the electro-conductive oxide in this invention is typically given by powder resistivity, and may be measured using "Type 3223" tester from Yokogawa Electric Corporation, by packing 10 g of pulverized electro-conductive oxide into a cylinder of 25 mm in inner diameter, having a Teflon (registered trademark) lining over the inner surface, and then pressurizing the powder at 100 kg/cm² (rate of filling = 20%).

While the LDS additive used in the fourth embodiment is not specifically limited so long as it contains an electro-conductive oxide having a resistivity of 5×10³ Ω·cm or smaller, it preferably contains at least two species of metals. More specifically, the LDS additive preferably contains Group n (n is an integer of 3 to 16) metal and Group n+1 metal in the periodic table. n is preferably an integer of 10 to 13, and more preferably 12 or 13.

In the LDS additive used in the fourth embodiment, assuming now the total of the content of Group n (n is an integer of 3 to 16) metal in the periodic table and the content of Group n+1 metal in the LDS additive as 100 mol%, the content of one metal is preferably 15 mol% or less, more preferably 12 mol% or less, and even more preferably 10 mol% or less. The lower limit is preferably, but not specifically limited to, 0.0001 mol% or above. By controlling the contents of two or more species of metals within such ranges, the platability may be improved. In this invention, a Group n metal oxide doped with Group n+1 metal is particularly preferable.

It is further preferable that, in the LDS additive used in the fourth embodiment, 98% by weight or more of the metal component contained in the LDS additive is composed of the Group n metal and Group n+1 metal in the periodic table.

Group n metals in the periodic table is exemplified by those of Group 3 (scandium, yttrium), Group 4 (titanium, zirconium, etc.), Group 5 (vanadium, niobium, etc.), Group 6 (chromium, molybdenum, etc.), Group 7 (manganese, etc.), Group 8 (iron, ruthenium, etc.), Group 9 (cobalt, rhodium, iridium, etc.), Group 10 (nickel, palladium, platinum), Group 11 (copper, silver, gold, etc.), Group 12 (zinc, cadmium, etc.), Group 13 (aluminum, gallium, indium, etc.), Group 14 (germanium, tin, etc.), Group 15 (arsenic, antimony, etc.), Group 16 (selenium, tellurium, etc.), and oxides of these metals. Among them, Group 12 (n=12) metals or metal oxides are preferable, and zinc is more preferable.

Group n+1 metals in the periodic table is exemplified by those of Group 4 (titanium, zirconium, etc.), Group 5 (vanadium, niobium, etc.), Group 6 (chromium, molybdenum, etc.), Group 7 (manganese, etc.), Group 8 (iron, ruthenium, etc.), Group 9 (cobalt, rhodium, iridium, etc.), Group 10 (nickel, palladium, platinum), Group 11 (copper, silver, gold, etc.), Group 12 (zinc, cadmium, etc.), Group 13 (aluminum, gallium, indium, etc.), Group 14 (germanium, tin, etc.), Group 15 (arsenic, antimony, etc.), Group 16 (selenium, tellurium, etc.), and oxides of these metals. Among them, metals in Group 13 (n+1=13) or metal oxides are preferable, aluminum or gallium is more preferable, and aluminum is even more preferable.

The LDS additive used in the fourth embodiment may contain a metal besides the electro-conductive metal oxide. The metal besides the electro-conductive metal oxide is exemplified by antimony, titanium, indium, iron, cobalt, nickel, cadmium, silver, bismuth, arsenic, manganese, chromium, magnesium, and calcium. These metals may exist in the form of oxides. The content of each of these metals is preferably 0.01% by weight or less, relative to the LDS additive.

In the LDS additive used in the fourth embodiment, the content of antimony is preferably 3% by weight or less relative to the LDS additive, in view of improving the L value, more preferably 1% by weight or less, and even more preferably 0.01% by weight or less. It is particularly preferable that the LDS additive contains substantially no antimony. Now the phrase of "contains substantially no ..." means that something is not contained to a degree which is influential to the effect of this invention.

The LDS additive used in the fourth embodiment is preferably capable of absorbing light of 1064 nm wavelength. With the ability of absorbing light of 1064 nm wavelength, the LDS additive will more easily form the plating layer on the surface of the resin molded article.

The LDS additive used in the fourth embodiment preferably has a particle size of 0.01 to 50 µm, and more preferably 0.05 to 30 µm. With such configuration, the plated surface after applied with a plating layer will tend to have an improved uniformity.

### <(D) Titanium Oxide>

The thermoplastic resin composition of this invention contains titanium oxide. With titanium contained therein, the thermoplastic resin composition will be improved in platability of the resin molded article, while keeping high reflectivity.

The thermal conductivity of titanium oxide is preferably 1 to 20 W/m·K, and more preferably 5 to 10 W/m·K.

Titanium oxide used in this invention is exemplified by titanium monoxide (TiO), dititanium trioxide (Ti₂O₃) and titanium dioxide (TiO₂). While any of them is usable, titanium dioxide is preferable. Titanium oxide used here preferably has the rutile-type crystal structure.

Average primary particle size of titanium oxide is preferably 1 µm or smaller, more preferably in the range from 0.001 to 0.5 µm, and even more preferably in the range from 0.002 to 0.1 µm. With the average particle size and the amount of mixing of titanium oxide controlled within the above-described ranges, the resultant resin molded article will have high whiteness and high reflectivity of the surface.

Titanium oxide used herein may be surface-treated. The surface treatment agent is preferably an inorganic material and/or organic material, which are specifically exemplified by metal oxides such as silica, alumina and zinc oxides; and organic materials such as silane coupling agent, titanium coupling agent, organic acid, polyol and silicone.

Titanium oxide used herein may alternatively be a commercially available product. It is also allowable to use titanium oxide having the average particle size controlled within the above-described ranges, by suitably crushing a lump or product having a larger average particle size, followed by optional classification through a mesh or the like.

The amount of mixing of titanium oxide in the thermoplastic resin composition of this invention is 10 to 130 parts by weight, per 100 parts by weight of the crystallizable thermoplastic resin, preferably 20 to 130 parts by weight, and even more preferably 25 to 125 parts by weight. With such amount of addition, degradation of reflectivity after annealing is avoidable. Among commercially available products of titanium oxide, those containing 80% by weight or more of titanium oxide are preferable, taking the whiteness and concealability into consideration.

The thermoplastic resin composition of this invention is preferable when the total content of (B) thermal conductive filler, (C) LDS additive, and (D) titanium oxide is 40 to 65% by weight relative to the thermoplastic resin composition, more preferably 50 to 65% by weight, and even more preferably 52 to 63% by weight. With the total content controlled in these ranges, the resin molded article produced from the thermoplastic resin composition of this invention will be more suitably balanced among various characteristics (resistance to soldering heat, platability, thermal conductivity, volume resistivity).

### <(E) Glass Fiber>

The thermoplastic resin composition of this invention may contain glass fiber. The glass fiber suitably used in this invention preferably has an average fiber diameter of 20 µm or smaller, and more preferably 1 to 15 µm, in view of improved balance among physical properties (strength, rigidity, rigidity under heating, impact strength), and reduced warping of molded article. While the glass fiber having a circular cross-section is most popularly used, also those having cocoon-like, oval and rectangular cross-sections are used in the same way in this invention, without special limitation.

The glass fiber preferably has a thermal conductivity of 0.1 to 2.0 W/m·K, and more preferably 0.5 to 1.0 W/m·K.

The glass fiber is not specifically limited regarding the length, and is selectable from those of filament type (roving), staple type (chopped strand) and so forth. The number of bundled filaments or strands in this case is preferably 100 to 5000 or around. So long as the length of glass fiber, after kneaded with the thermoplastic resin composition of this invention, will remain to be 0.1 mm or longer on average, the glass fiber may be a crushed product of strand generally called middle fiber or glass powder, and alternatively be a sliver of continuous filament. The source glass is exemplified by E-glass, C-glass and S-glass, where non-alkali type is preferable, and E-glass is suitably used in this invention.

The glass fiber is preferably surface-treated, for example, with a silane coupling agent such as γ-methacryloxypropyltrimethoxysilane, γ-glycidoxypropyltrimethoxysilane, and γ-aminopropyltriethoxysilane, wherein the amount of coating is typically 0.01 to 1% by weight relative to the weight of glass fiber. If necessary, it is further possible to use the glass fiber surface-coated with lubricant such as aliphatic amide compound and silicone oil; antistatic agent such as quaternary ammonium salt; film-forming resin such as epoxy resin and urethane resin; or mixture of film-forming resin with heat stabilizer, flame retardant or the like.

When the thermoplastic resin composition of this invention contains the glass fiber, the content of glass fiber is preferably 200 parts by weight or less, per 100 parts by weight of crystallizable thermoplastic resin, more preferably 150 parts by weight or less, even more preferably 100 parts by weight or less, and yet more preferably 50 parts by weight or less. The lower limit is preferably 10 parts by weight or above, and more preferably 20 parts by weight or above.

### <Talc>

The thermoplastic resin composition of this invention may contain talc. In this invention, by mixing talc, the platability of the laser-irradiated portion tends to improve.

Talc preferably has a thermal conductivity of 0.1 to 10 W/m·K, and more preferably 0.5 to 3 W/m·K.

When the thermoplastic resin composition of this invention contains talc, the content of talc is preferably 0.5 to 20 parts by weight, per 100 parts by weight of thermoplastic resin composition, more preferably 0.5 to 10 parts by weight, even more preferably 0.5 to 5 parts by weight, and yet more preferably 0.5 to 3 parts by weight.

### <Heat Stabilizer>

The thermoplastic resin composition of this invention may further contains organic and/or inorganic heat stabilizer, where the organic heat stabilizer is more preferable.

It is preferable that the heat stabilizer used in this invention contains substantially no copper. Now "contains substantially no ..." means that the content is below the detection limit. By thus limiting the copper content to such low level, the discoloration may be suppressed.

The organic heat stabilizer is preferably at least one species selected from the group consisting of phenol-based compound, phosphite-based compound, hindered amine-based compound, triazine-based compound, and sulfur-containing compound.

Only a single species of heat stabilizer may be used, or two or more species may be used in combination.

The phenol-based compound is exemplified by, but not specifically limited to, hindered phenol-based compound. The hindered phenol-based compound is exemplified by N,N'-hexane-1,6-diylbis[3-(3,5-di-*t*-butyl-4-hydroxyphenylpropion amide), pentaerythrityltetrakis[3-(3,5-di-*t*-butyl-4-hydroxyphenyl) propionate], N,N'-hexamethylenebis(3,5-di-*t*-butyl-4-hydroxy-hydrocinnamamide), triethylene glycol-bis[3-(3-*t*-butyl-5-methyl-4-hydroxyphenyl) propionate], 3,9-bis{2-[3-(3-*t*-butyl-4-hydroxy-5-methylphenyl) propynyloxyl-1,1-dimethylethyl}-2,4,8,10-tetraoxaspiro[5.5]undec ane, 3,5-di-t-butyl-4-hydroxybenzylphosphonate diethyl ester, 1,3,5-trimethyl-2,4,6-tris(3,5-di-*t*-butyl-4-hydroxybenzyl)benzen e, and 1,3,5-tris(4-*t*-butyl-3-hydroxy-2,6-dimethylbenzyl) isocyanuric acid.

The phosphite-based compound is exemplified by, but not specifically limited to, trioctyl phosphite, trilauryl phosphite, tridecyl phosphite, octyldiphenyl phosphite, trisisodecyl phosphite, phenyldiisodecyl phosphite, phenyldi(tridecyl) phosphite, diphenylisooctyl phosphite, diphenylisodecyl phosphite, diphenyl(tridecyl) phosphite, triphenyl phosphite, tris(nonylphenyl) phosphite, tris(2,4-di-*t*-butylphenyl) phosphite, tris(2,4-di-*t*-butyl-5-methylphenyl) phosphite, tris(butoxyethyl) phosphite, 4,4'-butylidene-bis(3-methyl-6-*t*-butylphenyl-tetra-tridecyl) diphosphite, tetra (C₁₂ to C₁₅ mixed alkyl)-4,4'-isopropylidenediphenyl diphosphite, 4,4'-isopropylidenebis(2-*t*-butylphenyl)·di(nonylphenyl) phosphite, tris(biphenyl) phosphite, tetra(tridecyl)-1,1,3-tris(2-methyl-5-*t*-butyl-4-hydroxyphenyl)bu tane diphosphite, tetra(tridecyl)-4,4'-butylidenebis(3-methyl-6-t-butylphenyl) diphosphite, tetra (C₁ to C₁₅ mixed alkyl)-4,4'-isopropylidenediphenyl diphosphite, tris(mono- and di-mixed nonylphenyl) phosphite, 4,4'-isopropylidenebis(2-*t*-butylphenyl)·di(nonylphenyl) phosphite, 9,10-dihydro-9-oxa-9-oxa-10-phosphaphenanthrene-10-oxide, tris(3,5-di-*t*-butyl-4-hydroxyphenyl) phosphite, hydrogenated-4,4'-isopropylidenediphenyl polyphosphite, bis(octylphenyl)·bis(4,4'-butylidenebis(3-methyl-6-*t*-butylphenyl ))·1,6-hexnol diphosphite, hexatridecyl-1,1,3-tris(2-methyl-4-hydroxy-5-*t*-butylphenyl) diphosphite, tris(4,4'-isopropylidenebis(2-*t*-butylphenyl)) phosphite, tris(1,3-stearoyloxyisopropyl) phosphite, 2,2-methylenebis(4,6-di-*t*-butylphenyl)octyl phosphite, 2,2-methylenebis(3-methyl-4,6-di-*t*-butylphenyl)-2-ethylhexyl phosphite, tetrakis(2,4-di-*t*-butyl-5-methylphenyl)-4,4'-biphenylene diphosphite, and tetrakis(2,4-di-t-butylphenyl)-4,4'-biphenylene diphosphite.

The phosphite-based compound is also exemplified by, but not specifically limited to, pentaerythritol-type phosphite compound. The pentaerythritol-type phosphite compound is exemplified by 2,6-di-*t*-butyl-4-methylphenyl·phenyl·pentaerythritol diphosphite, 2,6-di-*t*-butyl-4-methylphenyl·methyl·pentaerythritol diphosphite, 2,6-di-*t*-butyl-4-methylphenyl·2-ethylhexyl·pentaerythritol diphosphite, 2,6-di-*t*-butyl-4-methylphenyl·isodecyl·pentaerythritol diphosphite, 2,6-di-*t*-butyl-4-methylphenyl·lauryl·pentaerythritol diphosphite, 2,6-di-*t*-butyl-4-methylphenyl·isotridecyl·pentaerythritol diphosphite, 2,6-di-*t*-butyl-4-methylphenyl·stearyl ·pentaerythritol diphosphite, 2,6-di-*t*-butyl-4-methylphenyl·cyclohexyl·pentaerythritol diphosphite, 2,6-di-*t*-butyl-4-methylphenyl-benzyl-pentaerythritol diphosphite, 2,6-di-*t*-butyl-4-methylphenyl·ethylcellosolve·pentaerythritol diphosphite, 2,6-di-*t*-butyl-4-methylphenyl·butylcarbitol·pentaerythritol diphosphite, 2,6-di-*t*-butyl-4-methylphenyl·octylphenyl·pentaerythritol diphosphite, 2,6-di-*t*-butyl-4-methylphenyl·nonylphenyl·pentaerythritol diphosphite, bis(2,6-di-*t*-butyl-4-methylphenyl) pentaerythritol diphosphite, bis(2,6-di-*t*-butyl-4-ethylphenyl)pentaerythritol diphosphite, 2,6-di-*t*-butyl-4-methylphenyl·2,6-di-t-butylphenyl·pentaerythrit ol diphosphite, 2,6-di-*t*-butyl-4-methylphenyl·2,4-di-t-butylphenyl·pentaerythrit ol diphosphite, 2,6-di-*t*-butyl-4-methylphenyl·2,4-di-t-octylphenyl·pentaerythrit ol diphosphite, 2,6-di-*t*-butyl-4-methylphenyl·2-Cyclohexylphenyl·pentaerythritol diphosphite, 2,6-di-*t*-amyl-4-methylphenyl-phenyl-pentaerythritol diphosphite, bis(2,6-di-*t*-amyl-4-methylphenyl) pentaerythritol diphosphite, and bis(2,6-di-*t*-octyl-4-methylphenyl)pentaerythritol diphosphite.

The pentaerythritol-type phosphite compound is preferably bis(2,6-di-*t*-butyl-4-methylphenyl)pentaerythritol diphosphite, bis(2,6-di-*t*-butyl-4-ethylphenyl)pentaerythritol diphosphite, bis(2,6-di-*t*-amyl-4-methylphenyl)pentaerythritol diphosphite, or bis(2,6-di-*t*-octyl-4-methylphenyl)pentaerythritol diphosphite, wherein bis(2,6-di-*t*-butyl-4-methylphenyl) pentaerythritol diphosphite is more preferable.

The hindered amine-based compound is exemplified by, but not limited to, 4-acetoxy-2,2,6,6-tetramethylpiperidine, 4-stearoyloxy-2,2,6,6-tetramethylpiperidine, 4-acryloyloxy-2,2,6,6-tetramethylpiperidine, 4-(phenylacetoxy)-2,2,6,6-tetramethylpiperidine, 4-benzoyloxy-2,2,6,6-tetramethylpiperidine, 4-methoxy-2,2,6,6-tetramethylpiperidine, 4-stearyloxy-2,2,6,6-tetramethylpiperidine, 4-cyclohexyloxy-2,2,6,6-tetramethylpiperidine, 4-benzyloxy-2,2,6,6-tetramethylpiperidine, 4-phenoxy-2,2,6,6-tetramethylpiperidine, 4-(ethylcarbamoyloxy)-2,2,6,6-tetramethylpiperidine, 4-(cyclohexylcarbamoyloxy)-2,2,6,6-tetramethylpiperidine, 4-(phenylcarbamoyloxy)-2,2,6,6-tetramethylpiperidine, bis(2,2,6,6-tetramethyl-4-piperidyl) carbonate, bis(2,2,6,6-tetramethyl-4-piperidyl) oxalate, bis(2,2,6,6-tetramethyl-4-piperidyl) malonate, bis(2,2,6,6-tetramethyl-4-piperidyl) sebacate, bis(2,2,6,6-tetramethyl-4-piperidyl) adipate, bis(2,2,6,6-tetramethyl-4-piperidyl) terephthalate, 1,2-bis(2,2,6,6-tetramethyl-4-piperidyloxy)ethane, α,α'-bis(2,2,6,6-tetramethyl-4-piperidyloxy)-*p*-xylene, bis(2,2,6,6-tetramethyl-4-piperidyltolylene-2,4-dicarbamate, bis(2,2,6,6-tetramethyl-4-piperidyl)-hexamethylene-1,6-dicarbama te, tris(2,2,6,6-tetramethyl-4-piperidyl)benzene-1,3,5-tricarboxylat e, tris(2,2,6,6-tetramethyl-4-piperidyl)benzene-1,3,4-tricarboxylat e, 1-[2-{3-(3,5-di-*t*-butyl-4-hydroxyphenyl) propionyloxy}butyl]-4-[3-(3,5-di-*t*-butyl-4-hydroxyphenyl)propion yloxy]-2,2,6,6-tetramethylpiperidine, and condensate of 1,2,3,4-butanetetracarboxylic acid and 1,2,2,6,6-pentamethyl-4-piperidinol and β,β,β',β'-tetramethyl-3,9-(2,4,8,10-tetraoxaspiro[5.5] undecane) diethanol.

The triazine-based compound is exemplified by, but not specifically limited to, hydroxyphenyltriazines.

The hydroxyphenyltriazines are exemplified by 2,4,6-tris(2'-hydroxy-4'-octyloxyphenyl)-1,3,5-triazine, 2-(2'-hydroxy-4'-hexyloxyphenyl)-4,6-diphenyl-1,3,5-triazine, 2-(2'-hydroxy-4'-octyloxyphenyl)-4,6-bis(2',4'-dimethylphenyl)-1 ,3,5-triazine, 2-(2',4'-dihydroxyphenyl)-4,6-bis(2',4'-dimethylphenyl)-1,3,5-tr iazine, 2,4-bis(2'-hydroxy-4'-propyloxyphenyl)-6-(2',4'-dimethylphenyl)-1,3,5-triazine, 2-(2-hydroxy-4-octyloxyphenyl)-4,6-bis(4'-methylphenyl)-1,3,5-tr iazine, 2-(2'-hydroxy-4'-dodecyloxyphenyl)-4,6-bis(2',4'-dimethylphenyl) -1,3,5-triazine, 2,4,6-tris(2'-hydroxy-4'-isopropyloxyphenyl)-1,3,5-triazine, 2,4,6-tris(2'-hydroxy-4'-n-hexyloxyphenyl)-1,3,5-triazine, and 2,4,6-tris(2'-hydroxy-4'-ethoxycarbonylmethoxyphenyl)-1,3,5-tria zine.

The sulfur-containing compound is exemplified by, but not specifically limited to, pentaerythrityltetrakis(3-laurylthiopropionate), dilauryl-3,3'-thiodipropionate, dimyristyl-3,3'-thiodipropionate, and distearyl 3,3'-thiodipropionate.

The inorganic inorganic heat stabilizer is preferably metal hydroxide, and is exemplified by magnesium hydroxide, calcium hydroxide, and antimony trioxide. In particular, when the LDS additive is an acidic substance, alkali which is added as the inorganic heat stabilizer can also serve as a later-described alkali component for making the hue of the LDS additive uniform. In some cases, this sort of alkali may also serve as a heat stabilizer.

When the thermoplastic resin composition of this invention contains the heat stabilizer, the content of heat stabilizer is preferably 0.01 parts by weight to 5 parts by weight, per 100 parts by weight of the thermoplastic resin composition of this invention, more preferably 0.01 to 3 parts by weight, even more preferably 0.01 to 2.5 parts by weight, and particularly 0.03 to 2 parts by weight. If the heat stabilizer is too scarce, the heat stabilizing effect would be insufficient, meanwhile if the heat stabilizer is excessive, the effect would saturate to degrade the economy.

### <Photostabilizer>

The thermoplastic resin composition of this invention preferably contains an organic and/or inorganic photostabilizer, wherein the organic photostabilizer is more preferably contained.

The organic photostabilizer is exemplified by UV-absorbing compounds such as benzophenone-based compound, salicylate-based compound, benzotriazole-based compound, and cyano acrylate-based compound; and compounds with radical scavenging ability, such as hindered amine-based compound and hindered phenol-based compound.

Combined use of the compound with UV-absorbing ability, and the compound with radical scavenging ability, as the photostabilizer, will be successful to obtain higher stabilizing effect.

Only a single species of photostabilizer may be used, or two or more species may be used in combination.

The benzophenone-based compound is exemplified by, but not specifically limited to, 2-hydroxy-4-n-octoxybenzophenone, 2,2'-dihydroxy-4-methoxybenzophenone, 2,2'-dihydroxy-4,4'-dimethoxybenzophenone, 2,2'4,4'-tetrahydroxybenzophenone, 2-hydroxy-4-methoxybenzophenone, 2,4-dihydroxybenzophenone, and 2-hydroxy-4-octyloxybenzophenone.

The salicylate-based compound is exemplified, but not specifically limited to, phenyl salicylate, *p*-*t*-butylphenyl salicylate, and *p*-octylphenyl salicylate.

The benzotriazole-based compound is exemplified by, but not specifically limited to, 2-(2'-hydroxy-5'-methylphenyl) benzotriazole, 2-(3-*t*-butyl-5-methyl-2-hydroxyphenyl)-5-chlorobenzotriazole, 2-(2'-hydroxy-3',5'-di-*t*-butylphenyl) benzotriazole, 2-(2'-hydroxy-5'-*t*-octylphenyl) benzotriazole, 2-(2'-hydroxy-3'-*t*-butyl-5'-methylphenyl)-5-chlorobenzotriazole, 2-(2'-hydroxy-3',5'-di-*t*-butylphenyl)-5-chlorobenzotriazole, 2-(2'-hydroxy-3',5'-di-*t*-aminophenyl) benzotriazole, 2-{2'-hydroxy-3'-(3",4",5",6"-tetrahydrophthalimidomethyl)-5'-me thylphenyl}benzotriazole, 2,2-methylenebis{4-(1,1,3,3-tetramethylbutyl)-6-(2H-benzotriazol e-2-yl)phenol}, and 6-(2-benzotriazolyl)-4-*t*-octyl-6'-t-butyl-4'-methyl-2,2'-methyle nebisphenol.

The cyano acrylate-based compound is exemplified by, but not specifically limited to, 2-ethylhexyl-2-cyano-3,3'-diphenylacrylate, and ethyl-2-cyano-3,3'-diphenylacrylate.

The hindered amine-based compound is exemplified by, but not specifically limited to, bis(2,2,6,6-tetramethyl-4-piperidyl) sebacate, bis(2,2,6,6-tetramethyl-4-piperidyl) succinate, bis(1,2,2,6,6-pentamethyl-4-piperidyl) sebacate, bis(1-octyloxy-2,2,6,6-tetramethyl-4-piperidyl) sebacate, bis(1,2,2,6,6-pentamethyl-4-piperidyl) *n*-butyl-3,5-di-t-butyl-4-hydroxybenzylmalonate, condensate of 1-(2-hydroxyethyl)-2,2,6,6-tetramethyl-4-hydroxypiperidine with succinic acid, straight chain-like or cyclic condensate of N,N'-bis(2,2,6,6-tetramethyl-4-piperidyl) hexamethylenediamine with 4-*tert*-octylamino-2,6-dichloro-1,3,5-triazine, tris(2,2,6,6-tetramethyl-4-piperidyl) nitrilotriacetate, tetrakis(2,2,6,6-tetramethyl-4-piperidyl)-1,2,3,4-butane tetracarboxylate, 1,1'-(1,2-ethanediyl)-bis(3,3,5,5-tetramethylpiperazinone), 4-benzoyl-2,2,6,6-tetramethylpiperidine, 4-stearyloxy-2,2,6,6-tetramethylpiperidine, bis(1,2,2,6,6-pentamethylpiperidyl)-2-*n*-butyl-2-(2-hydroxy-3,5-d i-*t*-butylbenzyl) malonate, 3-*n*-octyl-7,7,9,9-tetramethyl-1,3,8-triazaspiro[4.5]decane-2,4-d ione, bis(1-octyloxy-2,2,6,6-tetramethylpiperidyl) sebacate, bis(1-octyloxy-2,2,6,6-tetramethylpiperidyl) succinate, N,N'-bis(2,2,6,6-tetramethyl-4-piperidinyl)-1,3-benzenedicarboxy amide, straight chain-like or cyclic condensate of N,N'-bis(2,2,6,6-tetramethyl-4-piperidyl)-hexamethylenediamine with 4-morpholino-2,6-dichloro-1,3,5-triazine, condensate of 2-chloro-4,6-bis(4-*n*-butylamino-2,2,6,6-tetramethylpiperidyl)-1, 3,5-triazine with 1,2-bis(3-aminopropylamino)ethane, condensate of 2-chloro-4,6-di-(4-*n*-butylamino-1,2,2,6,6-pentamethylpiperidyl)-1,3,5-triazine with 1,2-bis-(3-aminopropylamino)ethane, 8-acetyl-3-dodecyl-7,7,9,9-tetramethyl-1,3,8-triazaspiro[4.5]dec ane-2,4-dione, 3-dodecyl-1-(2,2,6,6-tetramethyl-4-piperidyl)pyrrolidine-2,5-dio ne, 3-dodecyl-1-(1,2,2,6,6-pentamethyl-4-piperidyl)pyrrolidine-2,5-d ione, mixture of 4-hexadecyloxy- and 4-stearyl oxy-2,2,6,6-tetramethylpiperidines, condensate of N,N'-bis(2,2,6,6-tetramethyl-4-piperidyl)hexamethylenediamine with 4-cyclohexylamino-2,6-dichloro-1,3,5-triazine, condensate of 1,2-bis(3-aminopropylamino)ethane with 2,4,6-trichloro-1,3,5-triazine and 4-butylamino-2,2,6,6-tetramethylpiperidine (CAS registry number [136504-96-6]); condensate of 1,6-hexanediamine with 2,4,6-trichloro-1,3,5-triazine and N,N-dibutylamine and 4-butylamino-2,2,6,6-tetramethylpiperidine (CAS registry number [192268-64-7]); N-(2,2,6,6-tetramethyl-4-piperidyl)-*n*-dodecylsuccinimide, N-(1,2,2,6,6-pentamethyl-4-piperidyl)-*n*-dodecylsuccinimide, 2-undecyl-7,7,9,9-tetramethyl-1-oxa-3,8-diaza-4-oxo-spiro[4.5]de cane, reaction product of 7,7,9,9-tetramethyl-2-cycloundecyl-1-oxa-3,8-diaza-4-oxo-spiro[4 .5]decane with epichlorohydrin, 1,1-bis(1,2,2,6,6-pentamethyl-4-piperidyloxycarbonyl)-2-(4-metho xyphenyl)ethene, N,N'-bis-formyl-N,N'-bis(2,2,6,6-tetramethyl-4-piperidyl)hexamet hylenediamine, diester of 4-methoxymethylenemalonic acid with 1,2,2,6,6-pentamethyl-4-hydroxypiperidine, poly[methylpropyl-3-oxy-4-(2,2,6,6-tetramethyl-4-piperidyl)]silo xane, reaction product of maleic anhydride-α-olefin copolymer with 2,2,6,6-tetramethyl-4-aminopiperidine or 1,2,2,6,6-pentamethyl-4-aminopiperidine, 2,4-bis[N-(1-cyclohexyloxy-2,2,6,6-tetramethylpiperidine-4-yl)-N -butylamino]-6-(2-hydroxyethyl)amino-1,3,5-triazine, 1-(2-hydroxy-2-methylpropoxy)-4-octadecanoyloxy-2,2,6,6-tetramet hylpiperidine, 5-(2-ethylhexanoyl)oxymethyl-3,3,5-trimethyl-2-morpholinone, Sanduvor (from Clariant; CAS registry number [106917-31-1]), 5-(2-ethylhexanoyl)oxymethyl-3,3,5-trimethyl-2-morpholinone, reaction product of 2,4-bis[(1-cyclohexyloxy-2,2,6,6-piperidine-4-yl) butylamino]-6-chloro-*s*-triazine with N,N'-bis(3-aminopropyl)ethylenediamine), 1,3,5-tris(N-cyclohexyl-N-(2,2,6,6-tetramethylpiperidine-3-one-4 -yl)amino)-*s*-triazine, 1,3,5-tris(N-cyclohexyl-N-(1,2,2,6,6-pentamethylpiperazine-3-one -4-yl)amino)-*s*-triazine, N,N',N",N"'-tetrakis-(4,6-bis-(butyl-(N-methyl-2,2,6,6-tetrameth ylpiperidine-4-yl)amino)-triazine-2-yl)-4,7-diazadecane-1,10-dia mine, and poly[[6-(1,1,3,3-tetramethylbutyl)amino-1,3,5-triazine-2,4-diyl] [(2,2,6,6-tetramethyl-4-piperidyl) imino]hexamethylene{(2,2,6,6-tetramethyl-4-piperidyl) imino}]. Among them, bis(2,2,6,6-tetramethyl-4-piperidyl) sebacate, bis(2,2,6,6-tetramethyl-4-piperidyl) succinate, bis(1,2,2,6,6-pentamethyl-4-piperidyl) sebacate, N,N'-bis(2,2,6,6-tetramethyl-4-piperidinyl)-1,3-benzenedicarboxy amide, and N,N',N",N"'-tetrakis-(4,6-bis-(butyl-(N-methyl-2,2,6,6-tetrameth ylpiperidine-4-yl)amino)-triazine-2-yl)-4,7-diazadecane-1,10-dia mine are preferable.

The hindered phenol-based compound is exemplified by, but not specifically limited to, pentaerythrityl-tetrakis{3-(3,5-di-*t*-butyl-4-hydroxyphenyl) propionate}, N,N-hexamethylenebis(3,5-di-*t*-butyl-4-hydroxy-hydrocinnamamide, triethylene glycol-bis{3-(3-t-butyl-5-methyl-4-hydroxyphenyl) propionate}, 3,9-bis{2-[3-(3-*t*-butyl-4-hydroxy-5-methylphenyl) propynyloxyl-1,1-dimethylethyl}-2,4,8,10-tetraoxaspiro[5.5]undec ane, 3,5-di-*t*-butyl-4-hydroxy-benzylphosphonate-diethyl ester, 1,3,5-trimethyl-2,4,6-tris(3,5-di-*t*-butyl-4-hydroxybenzyl)benzen e, and 1,3,5-tris(4-t-butyl-3-hydroxy-2,6-dimethylbenzyl) isocyanate.

When the thermoplastic resin composition of this invention contains the photostabilizer, the content of photostabilizer is preferably 0.01 parts by weight to 5 parts by weight per 100 parts by weight of the thermoplastic resin composition of this invention, more preferably 0.01 to 3 parts by weight, and even more preferably 0.03 to 2 parts by weight.

### <Alkali>

The thermoplastic resin composition of this invention may contain an alkali. When the LDS additive used in this invention is an acidic substance (pH6 or below, for example), it may be reduced in some combination to produce spotted hue. Addition of alkali will successfully make the hue of an obtainable resin molded article more uniform. Usable species of alkali include calcium hydroxide, magnesium hydroxide and so forth, without special limitation. Only a single species of alkali may be used, or two or more species may be used in combination.

The alkali preferably has a thermal conductivity of 0.01 to 5 W/m·K, and more preferably 0.1 to 3 W/m·K.

When the thermoplastic resin composition of this invention contains the alkali, the content of alkali is preferably 0.01 to 10% by weight of the content of the LDS additive, and more preferably 0.05 to 5% by weight, although depending on the species of LDS additive and the species of alkali.

### <Antioxidant>

The thermoplastic resin composition of this invention may contain an antioxidant. The antioxidant is preferably phenol-based antioxidant, and is more preferably exemplified by 2,6-di-butyl-4-methylphenol, *n*-octadecyl-3-(3',5'-di-*t*-butyl-4'-hydroxyphenyl) propionate, tetrakis[methylene-3-(3,5-di-*t*-butyl-4-hydroxyphenyl) propionate]methane, tris(3,5-di-*t*-butyl-4-hydroxybenzyl) isocyanurate, 4,4'-butylidenebis(3-methyl-6-*t*-butylphenol), triethylene glycol-bis[3-(3-*t*-butyl-hydroxy-5-methylphenyl) propionate], and 3,9-bis{2-[3-(3-*t*-butyl-4-hydroxy-5-methylphenyl) propionyloxyl-1,1-dimethylethyl}-2,4,8,10-tetraoxaspiro[5.5]unde cane. Among them, tetrakis[methylene-3-(3,5-di-*t*-butyl-4-hydroxyphenyl) propionate]methane is preferable.

When the thermoplastic resin composition of this invention contains the antioxidant, the content of antioxidant is preferably 0.01 to 5 parts by weight per 100 parts by weight of resin component, and more preferably 1 to 5 parts by weight. The thermoplastic resin composition of this invention may contain only a single species of antioxidant, or may contain two or more species. When two or more species are contained, the total content falls in the above-described ranges.

### <Mold Releasing Agent>

The thermoplastic resin composition of this invention may contain a mold releasing agent.

The mold releasing agent is exemplified by aliphatic carboxylic acid, ester of aliphatic carboxylic acid and alcohol, aliphatic hydrocarbon compound having a number-average molecular weight of 200 to 15,000, and polysiloxane-based silicone oil.

The aliphatic carboxylic acid is exemplified by saturated or unsaturated aliphatic monobasic, and dibasic or tribasic carboxylic acid. Now "aliphatic carboxylic acid" also encompasses alicyclic carboxylic acid. Among them, preferred aliphatic carboxylic acid is monobasic or dibasic carboxylic acid having 6 to 36 carbon atoms, and is more preferably aliphatic saturated monobasic carboxylic acid having 6 to 36 carbon atoms. Specific examples of such aliphatic carboxylic acid include palmitic acid, stearic acid, caproic acid, capric acid, lauric acid, arachic acid, behenic acid, lignoceric acid, cerotic acid, melissic acid, tetratriacontanoic acid, montanic acid, and adipic acid, azelaic acid.

The aliphatic carboxylic acid in the ester of aliphatic carboxylic acid and alcohol, usable here, may be same as the aliphatic carboxylic acids described previously. Meanwhile, the alcohol is exemplified by saturated or unsaturated, monohydric or polyhydric alcohols. These alcohols may have a substituent such as fluorine atom, aryl group or the like. Among them, monohydric or polyhydric saturated alcohol having 30 or less carbon atoms is preferable, and aliphatic or alicyclic saturated monohydric alcohol or aliphatic saturated polyhydric alcohol, having 30 or less carbon atoms, is more preferable.

Such alcohol is specifically exemplified by octanol, decanol, dodecanol, stearyl alcohol, behenyl alcohol, ethylene glycol, diethylene glycol, glycerin, pentaerythritol, 2,2-dihydroxyperfluoro propanol, neopentylene glycol, ditrimethylolpropane, and dipentaerythritol.

The ester of aliphatic carboxylic acid and alcohol is specifically exemplified by beeswax (mixture mainly composed of myricyl palmitate), stearyl stearate, behenyl behenate, stearyl behenate, glycerin monopalmitate, glycerin monostearate, glycerin distearate, glycerin tristearate, pentaerythritol monopalmitate, pentaerythritol monostearate, pentaerythritol distearate, pentaerythritol tristearate, and pentaerythritol tetrastearate.

Aliphatic hydrocarbon having a number-average molecular weight of 200 to 15,000 is exemplified by liquid paraffin, paraffin wax, microwax, polyethylene wax, Fischer-Tropsch wax, and α-olefin oligomer having 3 to 12 carbon atoms. Also alicyclic hydrocarbon is included in the aliphatic hydrocarbon. The aliphatic hydrocarbon preferably has a number-average molecular weight of 5, 000 or smaller.

Among them, paraffin wax, polyethylene wax or partial oxide of polyethylene wax are preferable, and, paraffin wax and polyethylene wax are more preferable.

When the thermoplastic resin composition of this invention contains the mold releasing agent, the content of mold releasing agent is preferably 0.001 to 2 parts by weight, per 100 parts by weight in total of the thermoplastic resin and the glass fiber, and more preferably 0.01 to 1 part by weight. If the content of mold releasing agent falls below the lower limit of the above-described ranges, the mold releasing effect may sometimes be insufficient, whereas if the content of mold releasing agent exceeds the upper limit of the above-described ranges, the hydrolysis resistance may sometimes degrade, and injection molding dies may be polluted.

The thermoplastic resin composition of this invention may contain other additive, without departing from the spirit of this invention. Such additive is exemplified by flame retarder, UV absorber, dye/pigment, fluorescent brightening agent, anti-dripping agent, antistatic agent, anti-clouding agent, lubricant, anti-blocking agent, fluidity modifier, plasticizer, dispersion aid, and antibacterial agent. Only a single species of these components may be used, or two or more species may be used in combination.

### <Method for manufacturing Thermoplastic Resin Composition>

An arbitrary method is selectable as the method for manufacturing the thermoplastic resin composition of this invention.

One exemplary method is to mix the thermoplastic resin, the glass fiber, the LDS additive and so forth using a mixing means such as a V-type blender to thereby prepare an all-in-one blend, and then to melt and knead the blend using a vented extruder for pelletizing. Another exemplary method relates to two-stage kneading, according to which all components other than the glass fiber are preliminarily mixed thoroughly, the mixture is then melt-kneaded using a vented extruder and pelletized, the obtained pellet is mixed with the glass fiber, and the mixture is melt-kneaded using a vented extruder.

Further, another exemplary method is such that all components other than the glass fiber are preliminarily mixed thoroughly using a V-type blender or the like, the preparation is fed through a first chute of a vented twin screw extruder, the glass fiber is fed through a second chute opened in midway of the extruder, and the mixture is melt-kneaded and pelletized.

In a preferred screw configuration in a kneading zone of the extruder, an element for promoting kneading is arranged on the upstream side, and an element with a pressurizing ability is arranged on the downstream side.

The element for promoting kneading is exemplified by progressive kneading disc element, orthogonal kneading disc element, wide kneading disc element, and progressive mixing screw element.

Heating temperature in the melt-kneading is suitably selectable typically in the range from 180 to 360°C. A too high temperature would promote generation of decomposition gas, leading to clouding. It is therefore preferable to select a suitable screw configuration taking shear heating into consideration. Antioxidant or heat stabilizer is preferably used, in order to suppress the decomposition in the process of kneading or subsequent molding.

### <Physical Properties of Resin Molded Article>

The resin molded article of this invention preferably has a volume resistivity of 1.0×10⁸ Ω·cm or larger, and more preferably 1.0×10¹⁰ Q·cm or larger. The upper limit is preferably, but not limited to, 1.0×10¹⁸ Q·cm or below. The resin molded article of this invention is only enough to have a portion which demonstrates the volume resistivity, and therefore does not always necessarily demonstrate the volume resistivity over the entire portion thereof.

The resin molded article of this invention preferably has a reflectivity at 450 nm wavelength of 25% or larger, more preferably 70% or larger, even more preferably 75% or larger, and particularly 80% or larger. The resin molded article of this invention is only enough to have a portion which demonstrates the reflectivity, and therefore does not always necessarily demonstrate the reflectivity over the entire portion thereof. With such reflectivity, the resin molded article is suitably used for applications where high

### reflectivity is required.

The resin molded article of this invention preferably has a thermal conductivity of 1.0 W/m·K or larger, more preferably 3.0 W/m·K or larger, even more preferably 5.0 W/m·K or larger, and particularly 7.0 W/m·K or larger. The upper limit is typically, but not specifically limited to, 20 W/m·K or below. The resin molded article of this invention is only enough to have a portion which demonstrates the thermal conductivity, and therefore does not always necessarily demonstrate the thermal conductivity over the entire portion thereof. With such thermal conductivity, the resin molded article is suitably used for applications where high reflectivity is required.

Methods of manufacturing the resin molded article are freely selectable, without special limitation, from methods of molding which have been widely employed for molding the thermoplastic resin composition. The methods are exemplified by injection molding, ultrahigh-speed injection molding, injection compression molding, two-color molding, hollow molding such as gas-assist molding, molding using a heat insulating mold, molding using a rapid heating mold, foaming (including supercritical fluid), insert molding, IMC (in-mold coating) molding, extrusion molding, sheet forming, thermoforming, rotational molding, lamination forming, press forming, and blow molding. Also a molding method based on the hot runner system may be used.

Next, steps of providing a plating layer on the surface of the resin molded article obtained by molding the thermoplastic resin composition of this invention will be explained referring to FIG. 1. FIG. 1 is a schematic drawing illustrating steps of providing a plating layer on the surface of a resin molded article 1, by laser direct structuring. While the resin molded article 1 is illustrated as a flat substrate in FIG. 1, it is not always necessarily flat, and may be a resin molded article which is partially or entirely bent. The resin molded article is not limited to final products, but may be various component.

Referring now back to FIG. 1, the resin molded article 1 is irradiated with laser 2. The laser used here is suitably selected, without special limitation, from known lasers which include YAG laser, excimer laser, and electromagnetic laser, wherein YGA laser is preferable. Also the wavelength of laser is not specifically limited. Preferred wavelength range is 200 nm to 1200 nm, and particularly preferred range is 800 to 1200 nm.

Upon irradiated with laser, the resin molded article 1 is activated only in portions 3 irradiated with laser. The resin molded article 1 in such activated state is subjected to a plating solution 4. The plating solution 4 is selectable widely from known plating solutions, without special limitation, wherein those containing, as the metal component, at least one species from copper, nickel, silver, gold and palladium (in particular, electroless plating solution) are preferable; those containing at least one species from copper, nickel, silver and gold (in particular, electroless plating solution) are more preferable; and those containing copper (in particular, electroless plating solution) is even more preferable. In short, the plating layer in this invention preferably has the metal component composed of at least one of above-described metals.

The method of subjecting the resin molded article 1 to the plating solution 4 is exemplified by, but again not specifically limited to, a method of putting the resin molded article into a liquid formulated with the plating solution. The resin molded article after being applied with the plating solution will have a plating layer 5 formed only in the laser-irradiated portion.

According to this invention, a circuit space of 1 mm or smaller, and even 150 µm or smaller may be achieved (where the lower limit is typically 30 µm or above, but not specifically limited thereto). In an exemplary process of plating, electroless plating may be followed by protection with nickel or gold, for the purpose of suppressing corrosion or degradation of circuit already formed. Alternatively, a similar process of electroless plating may be followed by electroplating, to thereby form a desired film thickness in a shorter time. The plating layer may be composed of a single layer, or may have a multi-layered structure.

The molded article obtained from the thermoplastic resin composition of this invention may be used for various applications including electronic parts such as connector, switch, relay and electroconductive circuit; reflective plates such as lamp reflector; sliding components such as gear and cam; automobile components such as air intake manifold; water section components such as sink; miscellaneous decorative components; film; sheet and fiber.

The thermoplastic resin composition of this invention may also be formed into a molded article with high whiteness and reflectivity. The whiteness (Hunter Lab color system) of the molded article obtained from the thermoplastic resin composition of this invention may be made as high as 92 or higher for example, and more preferably 94 or higher. The molded article obtained from the thermoplastic resin composition of this invention is also excellent in terms of heat resistance, and light stability in actual environments of use. Accordingly, the molded article obtained from the thermoplastic resin composition of this invention can serve as a component which functions to reflect light, in particular as an LED lighting circuit component, and preferably an LED reflector, reflecting plate or electro-conductive circuit.

The molded article obtained from the thermoplastic resin composition of this invention also functions as a resin molded article whose plating layer, when provided on the surface of a cellular phone component, has an antenna performance.

For other aspects, the descriptions of JP-A-2011-219620, JP-A-2011-195820, JP-A-2011-178873, JP-A-2011-168705 and JP-A-2011-148267 may be referred to, without departing from the spirit of this invention.

### EXAMPLE

This invention will further be detailed referring to Examples. All materials, amounts of consumption, ratios, details of processes and so forth described in Examples below may suitably be modified without departing from the spirt of this invention. The scope of this invention is therefore not limited by the specific examples described below.

### <Exemplary Manufacture 1>

### (Synthesis of Polyamide (PAPXD10))

In a 50-liter reaction vessel equipped with a stirrer, a partial condenser, a condenser, a thermometer, a dropping device and a nitrogen gas feed pipe, 8950 g (44.25 mol) of sebacic acid (product name: sebacic acid TA, from Itoh Oil Chemicals Co., Ltd.), 12.54 g (0.074 mol) of calcium hypophosphite, and 6. 45 g (0.079 mol) of sodium acetate were precisely weighed and placed. The reaction vessel was thoroughly replaced with nitrogen gas, pressurized with nitrogen gas to 0.4 MPa, and the content was heated under stirring from 20°C up to 190°C, to uniformly melt sebacic acid over 55 minutes. Next, 5960 g (43.76 mol) of paraxylylenediamine (from Mitsubishi Gas Chemical Company) was added dropwise under stirring over 110 minutes. In this duration, the inner temperature of the reaction vessel was continuously elevated up to 293°C. In the process of dropwise addition, the pressure was controlled to 0.42 MPa, and the generated water was removed out from the system, through the partial condenser and the condenser. The temperature of the partial condenser was controlled in the range from 145 to 147°C. After completion of the dropwise addition of paraxylylenediamine, the polycondensation reaction was allowed to continue for 20 minutes, while keeping the inner pressure of the vessel to 0.42 MPa. In this duration, the inner temperature of the reaction vessel was elevated up to 296°C. Thereafter, the inner pressure of the reaction vessel was reduced from 0.42 MPa down to 0.12 MPa over 30 minutes. In this duration, the inner temperature elevated up to 298°C. The pressure was then reduced at a rate of 0.002 MPa/min, down to 0.08 MPa over 20 minutes, to thereby control the content of components having molecular weights of 1,000 or smaller. The inner temperature of the reaction vessel upon completion of the pressure reduction was found to be 301°C. The system was then pressurized using nitrogen gas, the polymer was taken out in the form of strand through a strand die at an inner temperature of reaction vessel of 301°C and a resin temperature of 301°C, cooled with a cooling water at 20°C, pelletized, to obtain approximately 13 kg of polyamide resin. The cooling time in the cooling water was set to 5 minutes, and the taking-up speed of strand was set to 100 m/min. The product will be referred to as "PAPXD10", hereinafter. The melting point was found to be 290°C, and the glass transition point was found to be 80°C.

### <Exemplary Manufacture 2>

### (Synthesis of Polyamide (PAMP6))

Adipic acid was melt under heating in a reaction can with a nitrogen atmosphere and kept stirred, the temperature was then elevated to 270°C, while slowly dropping under pressure (0.35 MPa) a mixed diamine with a molar ratio of paraxylylenediamine (from Mitsubishi Gas Chemical Company) and metaxylylenediamine (from Mitsubishi Gas Chemical Company) of 3:7, to thereby adjust the molar ratio of diamine and adipic acid (from Rhodia) to approximately 1:1. After completion of the dropwise addition, the pressure was reduced down to 0.06 MPa, the reaction was allowed to continue for 10 minutes, to thereby control the content of components having molecular weights of 1,000 or smaller. The content was then taken out in the form of strand, pelletized using a pelletizer, to obtain polyamide. The polyamide will be referred to as "PAMP6", hereinafter. The melting point was found to be 256°C, and the glass transition point was found to be 75°C.

PAMXD6: Polyamide PAMXD6 resin, from Mitsubishi Gas Chemical Company, melting point = 243°C, glass transition point = 75°C

### <Thermal conductive Filler>

Boron nitride: Denka Boron Nitride SGP, from Denka Co., Ltd., thermal conductivity is 80 W/m·K, volume resistivity is 1.0×10¹⁴ Ω·cm or larger, hexagonal flake, average size is 18 µm
Aluminum nitride: FAN-f05, from Furukawa Denshi Co., Ltd., thermal conductivity is 170 W/m·K, volume resistivity is 1.0×10¹⁴ Ω·cm or larger, average size is 3 to 10 µm
Aluminum oxide: AX3-32, from Micron Company, thermal conductivity is 30 w/m·K, volume resistivity is 1.0×10¹⁴ Ω·cm or larger, average size is 2.5 to 4.5 µm
Carbon fiber: Dialead 223SE, from Mitsubishi Plastics, Inc., thermal conductivity is 140 W/m·K, volume resistivity is 6.0 Ω·cm

### <LDS additive>

CP5C: antimony doped tin oxide (tin oxide = 95% by weight, antimony oxide = 5% by weight, lead oxide = 0.02% by weight, copper oxide = 0.004% by weight) (from Keeling & Walker Ltd.)
Minatec 40CM: L value = 62.9, antimony-doped tin oxide ((SnₓSb₁₋ₓ)O₂: 43% by weight, mica + silicon dioxide: 57% by weight) (from Merck KGaA)
Black 1G: mainly composed of copper chromium oxide (cur₂O₄), from Shepherd Color Japan, Inc.
23K: Electroconductive zinc oxide (aluminum-doped zinc oxide) (zinc oxide = 99% by weight, aluminum oxide = 1% by weight) (from HakusuiTech Co., Ltd.)

### <Titanium Oxide>

CR-63: titanium dioxide, from Ishihara Sangyo Kaisha, Ltd., rutile-form, average primary size = 0.21 µm, thermal conductivity = 8.4 W/m·K

### <Glass Fiber>

286H (ECS03T-286H) : average diameter = 10 µm, circular cross-section, from Nippon Electric Glass Co., Ltd., thermal conductivity = 0.76 W/m·K

### <Antioxidant>

Irganox 1098: from BASF

### <Alkali (basic compound) >

Calcium hydroxide: thermal conductivity = 0.5 to 1 W/m·K

### <Talc>

MW5000S: talc, from Hayashi Kasei Co., Ltd., thermal conductivity = 1 to 2 W/m·K

### <Compound>

The individual components were respectively weighed according to the compositions summarized in Table below, the components other than the glass fiber were blended in a tumbler, the blend was fed to a twin screw extruder (TEM26SS, from Toshiba Machine Co., Ltd.) from the base thereof and melted, the glass fiber was fed from the side, and resin composition pellet was produced. Temperature of the extruder was set to 300°C.

### <Thermal Conductivity (MD Direction) >

The obtained resin composition pellet was dried at 120°C for 4 hours, and subjected to injection molding using an injection molding machine (α-100iA, from Fanuc Corporation) at a cylinder temperature of 300°C and a die temperature of 130°C, to mold an ISO dumbbell tensile specimen of 4.0 mm thick. The obtained specimen was cut in the TD direction (direction normal to the flow direction), and thermal conductivity in the MD direction (flow direction) was measured in compliance with ISO 22007-3.

### <Volume resistivity>

The obtained resin composition pellet was dried at 120°C for 4 hours, and subjected to injection molding using an injection molding machine (α-100iA, from Fanuc Corporation) at a cylinder temperature of 300°C and a die temperature of 130°C, to mold a disc specimen of 3.2 mm thick and 100 mm in diameter. Using the obtained specimen, volume resistivity was measured in compliance with JIS K6911, and evaluated as described below:
A: volume resistivity ≥ 1.0×10⁸ Ω·cm
B: volume resistivity < 1.0×10⁸ Ω·cm

### <Appearance of Plating (Platability) >

Injection molding was conducted, by injecting the resin through a fan gate of 60 mm wide and 1.5 mm thick, into a die having a cavity of 60×60 mm in size and 2 mm thick, at a cylinder temperature of 300°C and a die temperature of 130°C. The gate portion was cut off to obtain a plate specimen. The obtained specimen was 2 mm thick.

On a 10×10 mm area of the obtained plate specimen, laser was irradiated using a laser irradiation apparatus VMc1 from Trumpf (YAG laser of 1064 nm wavelength, maximum output = 15 W), at an output of 60%, a frequency of 100 kHz, and a speed of 4 m/s. The subsequent plating was conducted in an electroless plating bath ENPLATE LDS CU 400 PC from Enthone, at 48°C. The platability was evaluated by visual observation of the thickness of copper layer formed by plating over 20 minutes.

Evaluation is as follows. Results are summarized in Table 1 below.
A: Good appearance (dark copper color, indicating thick coating by plating)
B: Plated, but thin somehow (not a practical level)

### <Reflectivity at 450 nm>

Injection molding was conducted in the same way as descried above regarding "Appearance of Plating (Platability)", to produce a specimen of 60 × 60 mm in size and 2 mm in thickness. The reflectivity at 450 nm wavelength was measured using visible/UV spectrometer UV-3100PC from Shimadzu Corporation. The wavelength 450 nm falls in the emission wavelength range of blue light emitting diode. The molded article is judged to have a good reflectivity if it shows an initial reflectivity of 70% or larger, and is judged to be suitable for applications where high reflectivity is required.

### <Resistance to soldering heat>

Injection molding was conducted in the same way as descried above regarding "Appearance of Plating (Platability) ", but to produce a specimen of 60 × 60 mm in size and 0.8 mm in thickness. The specimen was immersed in a soldering bath at 240°C for one minute, and the degree of deformation was visually observed. Evaluation is as follows.
A: The specimen did not deform after one minute of immersion, showing good appearance.
B: The specimen slightly deformed at the corners, within one minute.
C: The specimen notably deformed within one minute.

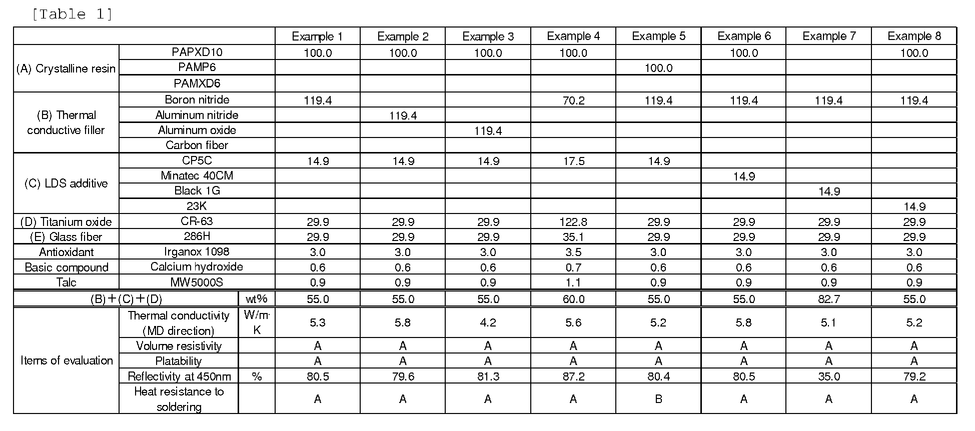

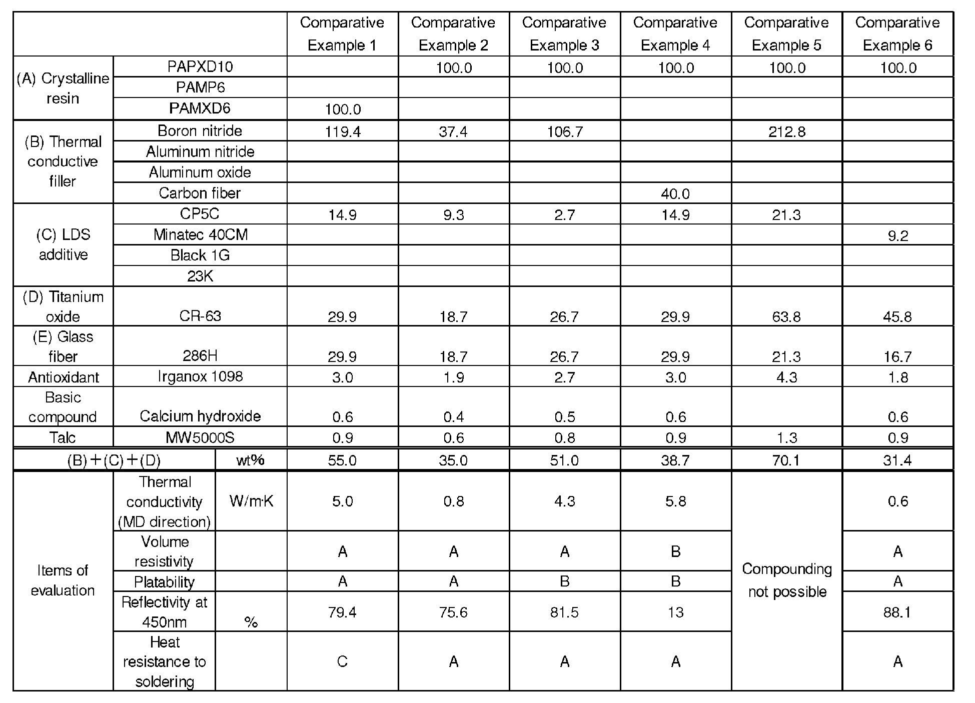

In Table above, (B) + (C) + (D) represents the ratio (in % by weight) of these components in the thermoplastic resin composition.

As is clear from the results, the thermoplastic resin composition of this invention was found to have high thermal conductivity, high volume resistivity, high resistance to soldering heat, and good platability. In contrast, Comparative Example 1 configured by using a resin composition, in which the (A) crystallizable thermoplastic resin did not have a melting point of 250°C or higher, was found to show a poor resistance to soldering heat . Each of Comparative Example 2 in which the (B) insulating thermal conductive filler was less than 40 parts by weight per 100 parts by weight of crystallizable thermoplastic resin, and, Comparative Example 6 which did not use the (B) insulating thermal conductive filler, showed the total of the (B) insulating thermal conductive filler, (C) LDS additive, and (D) titanium oxide fallen out of the range from 40 to 65% by weight relative to the crystallizable thermoplastic resin, and was found to show a poor heat conduction performance. Each of Comparative Examples 3 and 5 in which the content of the LDS additive falls outside the range from 3 to 20 parts by weight per 100 parts by weight of the crystallizable thermoplastic resin, could not be compounded, or showed only a poor platability if the compounding should be possible. In addition, Comparative Example 4 which was configured using an electro-conductive thermal conductive filler, in place of using the (B) insulating thermal conductive filler, was found to show a poor resistivity and platability.

It was also found that, by mixing titanium oxide, and by employing the LDS additive which contains tin and antimony, the reflectivity was improved.

### REFERENCE SIGNS LIST

1 resin molded article, 2 laser, 3 laser-irradiated portion, 4 plating solution, 5 plating layer

## Claims

1. A thermoplastic resin composition comprising:
per (A) 100 parts by weight of crystallizable thermoplastic resin showing a melting point of 250°C or higher when measured by differential scanning colorimetry (DSC) at a temperature elevation rate of 10°C/min; (B) 40 to 150 parts by weight of insulating thermal conductive filler showing a thermal conductivity of 10 w/m·K or larger; (C) 3 to 20 parts by weight of laser direct structuring additive; and (D) 10 to 130 parts by weight of titanium oxide;
wherein a total content of the (B) insulating thermal conductive filler, the (C) laser direct structuring additive and the (D) titanium oxide is 40 to 65% by weight of the resin composition.

2. The thermoplastic resin composition of Claim 1, further comprising (E) 10 to 200 parts by weight of glass fiber, per (A) 100 parts by weight of the crystallizable thermoplastic resin.

3. The thermoplastic resin composition of Claim 1 or 2,
wherein the (A) crystallizable thermoplastic resin is a polyamide resin.

4. The thermoplastic resin composition of any one of Claims 1 to 3,
wherein the (B) insulating thermal conductive filler is at least one species selected from boron nitride, aluminum nitride and aluminum oxide.

5. The thermoplastic resin composition of any one of Claims 1 to 4,
wherein the (C) laser direct structuring additive is one or more species selected from the group consisting of:
(1) additive containing antimony and tin;
(2) additive containing copper-containing oxide;
(3) additive comprising a core which is composed of a composition having a reflectivity of 50% or larger at 450 nm wavelength, the surface of which being partially or entirely coated with a composition containing at least one of copper-containing oxide, and, tin and antimony-containing oxide; and
(4) additive containing at least two species of metals, and an electro-conductive oxide having a resistivity 5×10³ Ω·cm or smaller.

6. A thermoplastic resin composition comprising:
per 100 parts by weight of xylylenediamine-based polyamide resin, in which 70 mol% or more of its diamine-derived constitutive unit being derived from metaxylylenediamine and/or paraxylylenediamine, and 70 mol% or more of its dicarboxylic acid-derived constitutive unit being derived from an α,ω-straight chain aliphatic dicarboxylic acid having 4 to 20 carbon atoms;
(B) 40 to 150 parts by weight of insulating thermal conductive filler showing a thermal conductivity of 10 W/m·K or larger;
(C) 3 to 20 parts by weight of laser direct structuring additive; and
(D) 10 to 130 parts by weight of titanium oxide;
wherein a total content of the (B) insulating thermal conductive filler, the (C) laser direct structuring additive and the (D) titanium oxide being 40 to 65% by weight relative to the resin composition.

7. A resin molded article obtained by molding the thermoplastic resin composition described in any one of Claims 1 to 6.

8. The resin molded article of Claim 7, wherein the volume resistivity is 1.0×10⁸ Ω·cm or larger.

9. The resin molded article of Claim 7 or 8, wherein the reflectivity at 450 nm wavelength is 25% or larger.

10. The resin molded article of any one of Claims 7 to 9, which has a thermal conductivity of larger than 1.0 W/m·K.

11. The resin molded article of any one of Claims 7 to 10,
further comprising a plating layer provided to a surface thereof.

12. The resin molded article of any one of Claims 7 to 11, which is an LED lighting circuit component.

13. A method for manufacturing a resin molded article with a plating layer, the method comprising:
irradiating, with laser, the surface of a resin molded article obtained by molding the thermoplastic resin composition described in any one of Claims 1 to 6, and applying a metal to form the plating layer.

14. The method for manufacturing a resin molded article with a plating layer of Claim 13,
wherein the plating layer is a copper plating layer.
